# EUROPÄISCHE PATENTSCHRIFT

(11) **EP 3 295 570 B1**
(45) Veröffentlichungstag und Bekanntmachung des Hinweises auf die Patenterteilung: **24.07.2024**
(21) Anmeldenummer: 16721374.3
(22) Anmeldetag: 21.04.2016
(51) Int. Cl.: H04B 1/00, H04B 1/04, H04B 1/10, H04B 1/18

(54) **HF-SCHALTUNG UND FRONTEND-SCHALTUNG MIT HF-SCHALTUNG**
HF CIRCUIT AND FRONT-END CIRCUIT COMPRISING AN HF CIRCUIT
CIRCUIT HF ET CIRCUIT D'ENTRÉE COMPRENANT UN CIRCUIT HF

(30) Priorität: 11.05.2015 DE 102015107305
(43) Veröffentlichungstag der Anmeldung: 21.03.2018
(73) Patentinhaber: SnapTrack, Inc., San Diego, CA 92121 (US)
(72) Erfinder: ELLÄ, Juha, 24800 Halikko (FI); SCHMIDHAMMER, Edgar, 83371 Stein an der Traun (DE); KOLB, Gabriele, 80637 München (DE); JOVOVIC, Ratko, 81539 München (DE)
(74) Vertreter: Bardehle Pagenberg Partnerschaft mbB Patentanwälte Rechtsanwälte
(86) Internationale Anmeldenummer: PCT/EP2016/058917
(87) Internationale Veröffentlichungsnummer: WO 2016/180613

(56) Entgegenhaltungen:
- KR-A- 20070 068 103
- US-A1- 2004 248 539
- US-A1- 2005 206 478

## Beschreibung

Die Erfindung betrifft HF-Schaltungen, die z. B. in Frontend-Schaltungen von Mobilfunkgeräten Verwendung finden können.

Frontend-Schaltungen von Mobilfunkgeräten verbinden einen oder mehrere Empfangs- oder Sendeverstärker mit einer oder mehreren Antennen. Diese Verbindung erfolgt über Signalpfade und HF-Filter, die so miteinander verschaltet sind, dass die Anforderungen an die Signalqualität der Mobilfunkgeräte erfüllt werden und gleichzeitig eine Vielzahl an Übertragungssystemen und Übertragungsfrequenzen genutzt werden können.

Aus der Patentschrift US 7,212,789 B2 sind HF-Schaltungen mit einem abstimmbaren Duplexer bekannt.

Während bereits bei üblichen FSS Systemen (FDD = frequency division duplexing = Frequenzduplex) Sende- und Empfangsfrequenzen gleichzeitig benutzt werden, können zur Erhöhung der Datenübertragungsrate verschiedene Sendefrequenzen gleichzeitig oder verschiedene Empfangsfrequenzen gleichzeitig benutzt werden (Carrier Aggregation). In Interband Carrier Aggregation Systemen können zwei FDD Empfangsfrequenzen zusammen mit einer FDD Sendefrequenz gleichzeitig benutzt werden. Es ist auch möglich, dass zwei FDD Sendefrequenzen zusammen mit einer Empfangsfrequenz oder mehreren Empfangsfrequenzen gleichzeitig benutzt werden (Tx Carrier Aggregation).

Ein solches gemeinsames Benutzen verschiedener Frequenzbänder wird aber bei üblichen HF-Schaltungen Probleme bereiten, da diese insbesondere bezüglich der Trennung verschiedener Signalpfade nicht an die zusätzliche HF-Leistung angepasst sind.

US 2005/206478 A1 offenbart einen verkleinerten und stromsparenden Antennenduplexer.

US 2004/248539 A1 offenbart ein Hochfrequenzmodul, welches einen Schaltkreis mit einer Phasenschieberschaltung beinhaltet.

KR20070068103 A offenbart ein Multiband-Schaltmodul, um mobile Kommunikation in einem zellularen oder US-PCS-Band auszuführen und gleichzeitig GPS-Empfang in Zeitserien durchzuführen.

Es ist deshalb eine Aufgabe, eine HF-Schaltung anzugeben, die eine gute Trennung zwischen verschiedenen Signalpfaden ermöglicht, auch wenn die Schaltung mit HF-Signalen verschiedener Frequenzbänder beaufschlagt wird. Insbesondere die Störung eines Signalpfads aufgrund von Intermodulationsprodukten soll verringert sein.

Diese Aufgabe wird durch die unabhängigen Ansprüche gelöst. Abhängige Ansprüche geben vorteilhafte Ausgestaltungen an.

Eine HF-Schaltung umfasst dazu einen Diplexer, einen ersten Duplexer für ein erstes Frequenzband und einen ersten Duplexer für ein zweites Frequenzband. Der Diplexer hat einen ersten Port, einem gemeinsamen Port und einen zweiten Port. Der erste Duplexer für das erste Frequenzband hat einen Sendeport, einen gemeinsamen Port und einen Empfangsport. Der erste Duplexer für das zweite Frequenzband hat ebenfalls einen Sendeport, einen gemeinsamen Port und einen Empfangsport. Die Schaltung umfasst ferner einen ersten Signalpfad zwischen dem gemeinsamen Port des ersten Duplexers des ersten Frequenzbands und dem ersten Port des Diplexers. Ferner umfasst die HF-Schaltung einen zweiten Signalpfad zwischen dem gemeinsamen Port des ersten Duplexers, des zweiten Frequenzbands und dem zweiten Port des Diplexers. Weiterhin umfasst die Schaltung einen Phasenschieber, der im zweiten Signalpfad angeordnet ist. Der Phasenschieber ist dazu vorgesehen, die Impedanzen des ersten Duplexer des zweiten Frequenzbands und des Diplexers für zumindest eine Harmonische eines der Frequenzbänder so anzupassen, dass zumindest ein Intermodulationsprodukt reduziert ist.

Die Impedanzanpassung betrifft dabei insbesondere die Impedanz des gemeinsamen Ports des ersten Duplexers des zweiten Signalpfads und des zweiten Ports des Diplexers.

Die Harmonische kann dabei insbesondere die zweite oder dritte Harmonische von Sendefrequenzen, z. B. des ersten Frequenzbands sein.

Die verbesserte Signaltrennung einer solchen HF-Schaltung ist damit auf die Verringerung der Intermodulationsprodukte zurückzuführen. Es wurde erkannt, dass in üblichen HF-Schaltungen von Frontend-Schaltungen die Isolation eines verwendeten Diplexers so schlecht sein kann, dass unerwünscht in einem Signalpfad eintretende HF-Signale aufgrund von nicht linearen Effekten in einem dem Diplexer nachgeschalteten Duplexer Intermodulationsprodukte bewirken können. Deren Frequenzen liegen im Durchlassbereich des Duplexers. Solche unerwünschten HF-Signale können dann durch übliche HF-Filter nicht weiter eliminiert werden, da ihre Frequenzen den Frequenzen gewünschter Signale gleichen.

Durch den Phasenschieber wird die Entstehung dieser Intermodulationsprodukte effizient verhindert oder zumindest so stark abgeschwächt, dass die unerwünschten aber deutlich schwächeren Intermodulationsprodukte nicht weiter stören.

Diese HF-Schaltung ist dabei kompatibel mit üblichen Schaltungstopologien von Frontend-Schaltungen, wobei dem vergleichsweise großen Zugewinn an Signalqualität ein vergleichsweise geringer zusätzlicher Schaltungsaufwand entgegensteht.

Es ist möglich, dass der Diplexer ein Keramik-Diplexer ist.

Ein solcher Keramik-Diplexer kann dabei einen Grundkörper aus einem isolierenden Material, z. B. Keramik, umfassen. In dem Grundkörper können Ausnehmungen, deren innere Oberflächen von einer Metallisierung bedeckt sind, vorgesehen sein. Ein solcher Diplexer weist typischerweise schon eine sehr hohe Linearität auf.

Es ist möglich, dass das erste Frequenzband, das 2-Gigahertz-Band und das zweite Frequenzband das 1-Gigahertz-Band ist. Das erste Frequenzband umfasst dann im Wesentlichen die Frequenzen zwischen 1 GHz und 2 GHz, insbesondere zwischen 1,4 und 2,2 GHz. Das zweite Frequenzband umfasst dann im Wesentlichen Frequenzen ≤ 1 GHz.

Es ist auch möglich, dass das erste Frequenzband und das zweite Frequenzband aus den drei Frequenzbereichen: Tiefes Band (Low Band, LB, ca. 650 bis 1000 MHz), mittleres Band (Mid Band, MB, 1700 - 2200 MHz) und Hochband (High Band, HB, Frequenzen f im Wesentlichen > 2500 MHz) ausgewählt sind.

Insbesondere die Mobilfunkfrequenzbänder 1, 2, 3, 4, 5, 7, 8, 12, 17, 19, 20, 21, 26 oder 28 können - z. B. für Carrier Aggregation bei Sendefrequenzen - als erstes Frequenzband oder als zweites Frequenzband in Frage kommen. Dabei sind die Mobilfunkbänder 5, 8, 12, 17, 19, 20, 26 und 28 dem LB zugeordnet. Die Mobilfunkbänder 1, 2, 3, 4, 21 sind dem MB zugeordnet und das Frequenzband 7 ist dem HB zugeordnet.

So können z. B. die folgenden Frequenzband-Paare zusammen verwendet werden:
LB und LB: 5 und 12, 5 und 17;
LB und MB: 3 und 5, 1 und 5, 3 und 20, 1 und 19, 3 und 8, 4 und 12, 4 und 17, 3 und 26, 3 und 19, 19 und 21;
MB und MB: 1 und 21, 2 und 4;
MB und HB: 1 und 7, 3 und 7, 4 und 7;
LB und HB: 7 und 20, 7 und 28, 5 und 7.

Es ist auch möglich, dass die HF-Schaltung ferner einen zweiten oder mehrere weitere Duplexer des ersten Frequenzbands umfasst. Der zweite Duplexer oder die mehreren weiteren Duplexer des ersten Frequenzbands sind dabei parallel zum ersten Duplexer des ersten Frequenzbands einerseits und mit dem ersten Signalpfad andererseits verschaltbar. Dann ist ein Übertragungsbetrieb - ob gleichzeitig oder hintereinander - über verschiedene Duplexer des ersten Frequenzbands möglich.

Es ist auch möglich, dass die HF-Schaltung noch eine Schalteranordnung umfasst, über die der erste Port des Diplexers mit dem zweiten oder mehreren weiteren der Duplexer des ersten Frequenzbands verschaltbar ist. Über die Schalteranordnung kann dabei individuell eingestellt werden, welcher der Duplexer mit dem Diplexer verschaltet sein soll. Es ist möglich, dass zu jeder Zeit stets genau ein Duplexer mit dem Diplexer verschaltet ist. Es ist aber auch möglich, dass zu einem Zeitpunkt auch gar kein Duplexer oder gleichzeitig mehrere Duplexer mit dem Diplexer verschaltet sind.

Ferner ist es möglich, dass die HF-Schaltung einen zweiten oder mehrere weitere Duplexer des zweiten Frequenzbands umfasst. Der zweite oder weitere Duplexer des zweiten Frequenzbands sind parallel zum ersten Duplexer des zweiten Frequenzbands einerseits und mit dem zweiten Signalpfad andererseits verschaltbar.

Auch dabei ist es möglich, dass die HF-Schaltung ferner eine weitere Schalteranordnung umfasst, über die der zweite Port des Diplexers mit einem oder mehreren der Duplexer des zweiten Frequenzbands verschaltbar ist.

Analog zur oben genannten Situation des ersten Frequenzbands kann somit auch die Zahl der Duplexer des zweiten Frequenzbands, die mit dem Diplexer verschaltet sind, individuell eingestellt sein.

Gemäß der Erfindung ist der Phasenschieber abstimmbar. Unter einem abstimmbaren Phasenschieber kann insbesondere ein Phasenschieber verstanden werden, dessen charakteristische Frequenzen und/oder der Phasenversatz für relevante Frequenzen einstellbar sein.

Es ist möglich, dass pro Duplexer des zweiten Frequenzbands ein Phasenschieber im zweiten Signalpfad vorgesehen ist.

Umfasst die HF-Schaltung mehrere Phasenschieber, so können diese beliebig aus den oben genannten Alternativen ausgewählt sein. Es ist allerdings auch möglich, dass mehrere oder alle Phasenschieber vom gleichen Typ sind.

Der Phasenschieber kann ein vom Diplexer kommendes unerwünschtes Signal zum Diplexer reflektieren. Erwünschte Signale im entsprechenden Frequenzbereich können den Diplexer ohne wesentlichen Leistungsverlust passieren. Gemäß der Erfindung ist der Phasenschieber ein abstimmbarer Phasenschieber, bei dem der Grad der Verschiebung der Phase eines Signals mit einer bestimmten Frequenz einstellbar ist. Z. B. variiert der durch den Phasenschieber verursachte Phasenversatz vorzugsweise linear der Frequenz des anliegenden Signals.

Ein als Phasenschieber ausgestalteter Phasenschieber kann insbesondere ein Allpass-Filter aus Induktivitäten und Kapazitäten sein.

Auch die Verwendung einer Streifenleitung als Phasenschieber ist möglich.

Es ist insbesondere möglich, dass die HF-Schaltung in einem Mobilfunkgerät, z. B. in einer Frontend-Schaltung des Mobilfunkgeräts, verschaltet ist. Ein Mobilfunkgerät, dessen Frontend-Schaltung eine solche HF-Schaltung umfasst, stellt dem Benutzer eine erhöhte Datenrate bei gleichzeitig nicht verschlechterter Signalqualität zur Verfügung.

Die Zahl der Duplexer pro erstem oder zweitem Frequenzband ist dabei nicht beschränkt. Sowohl das erste als auch das zweite Frequenzband können unabhängig voneinander über 1, 2, 3, 4 oder mehr Duplexer verfügen.

Das erste Frequenzband kann über 1, 2, 3, 4, 5 oder mehr Duplexer verfügen. Auch das zweite Frequenzband kann über 1, 2, 3, 4, 5 oder mehr Duplexer verfügen.

Im Folgenden werden zentrale Prinzipien der HF-Schaltung und einige nicht abschließende Ausführungsbeispiele anhand schematischer Figuren näher erläutert.

Es zeigen:
- Figur 1: den prinzipiellen Aufbau einer HF-Schaltung,
- Figur 2: eine Ausgestaltung mit mehreren Duplexern des ersten Frequenzbands,
- Figur 3: eine Ausgestaltung mit mehreren Duplexern des zweiten Frequenzbands,
- Figur 4: eine Ausgestaltung mit einem abstimmbaren Phasenschieber,
- Figur 5: eine Ausgestaltung mit mehreren Duplexern des ersten Frequenzbands und mehreren Duplexern des zweiten Frequenzbands,
- Figur 6: charakteristische Übertragungskurven eines typischen Diplexers,
- Figur 7: charakteristische Übertragungskurven eines typischen Diplexers mit etwas besserer Isolation,
- Figur 8: die Wirkung eines Phasenschiebers innerhalb einer HF-Schaltung anhand verschiedener Kurven, die jeweils ein Maß eines Intermodulationsproduktes darstellen, bei verschiedenen Werten des Phasenversatzes,
- Figur 9: die Wirkung eines Phasenschiebers innerhalb einer HF-Schaltung mit verbessertem Diplexer anhand verschiedener Kurven, die jeweils ein Maß eines Intermodulationsproduktes darstellen, bei verschiedenen Werten des Phasenversatzes,
- Figur 10: die Abhängigkeit der Stärke von Intermodulationsprodukten von einer Phasendrehung durch den Phasenschieber bei der Mittenfrequenz.

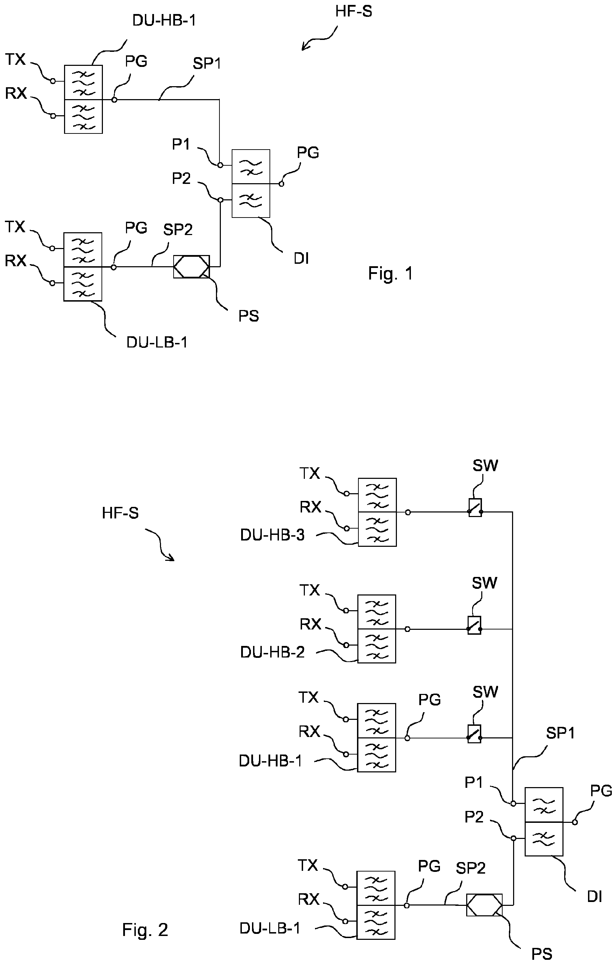

Figur 1 zeigt eine einfache Ausführungsform einer HF-Schaltung HF-S mit einem ersten Duplexer eines ersten Frequenzbands DU-HB-1, einem ersten Duplexer eines zweiten Frequenzbands DU-LB-1 und einem Diplexer DI. Den ersten Duplexer des zweiten Frequenzbandes DU-LB-1 verbindet ein zweiter Signalpfad SP2 mit dem zweiten Port P2 des Diplexers DI. Im zweiten Signalpfad SP2 ist ein Phasenschieber PS verschaltet. Den gemeinsamen Port PG des ersten Duplexers des ersten Frequenzbands DU-HB-1 verbindet ein erster Signalpfad SP1 mit dem ersten Port P1 des Diplexers DI. Der gemeinsame Port PG des Diplexers DI kann mit einer Antenne eines Kommunikationsgeräts verschaltet sein. Jeder der beiden Duplexer hat einen Sendeport TX und einen Empfangsport RX. Über die Sende- und Empfangsports können die beiden Duplexer mit einer oder mehrerer Transceiverschaltungen eines Mobilfunkgeräts verschaltet sein.

Kritisch beim Betrieb einer konventionellen HF-Schaltung ist folgende Situation: Über beide Sendeports TX beider Duplexer wird ein Sendesignal eingekoppelt, welches über die Signalpfade SP1 und SP2 zum Diplexer DI gelangt. Aufgrund der endlichen Isolation des Diplexers DI wird ein Teil des Sendesignals aus dem ersten Frequenzband in den zweiten Signalpfad SP2 in Richtung des Duplexers des zweiten Frequenzbands eingekoppelt. Typischerweise sind die Duplexer selbst Schaltungen mit nicht ausschließlich linearem Verhalten, wobei in diesem Fall verschiedene TX-Signale am TX-Filter des Duplexer des zweiten Frequenzbands DU-LB-1 zusammen treffen. Aufgrund von nichtlinearen Effekten des Duplexers des zweiten Frequenzbands entsteht ein Intermodulationsprodukt, welches gegebenenfalls das Empfangsfilter RX passieren kann und den gleichzeitigen Empfang des Kommunikationsgeräts stört oder gar verhindert. Soll das Kommunikationsgerät beispielsweise gleichzeitig in den Bändern 3 und 5 senden, so kann ein Intermodulationsprodukt bei 1710 MHz - 824 MHz = 886 MHz entstehen. Dieses liegt innerhalb des Band 5-Empfangsfrequenzbandes (RX) und kann deshalb das Empfangsfilter quasi ungedämpft passieren.

In der vorliegenden HF-Schaltung HF-S wird ein vom Diplexer DI in den zweiten Signalpfad 2 leckendes Signal so vom Phasenschieber in seiner Phasenlage verschoben, dass ein Mischen mit dem Sendesignal für den zweiten Signalpfad SP2 am Duplexer nicht erfolgen kann. So wird schon das Entstehen des Intermodulationsprodukts bei 886 MHz so verhindert oder seine Intensität abgeschwächt, dass ein Empfangsbetrieb problemlos möglich ist.

Figur 2 zeigt eine Ausführungsform, bei der drei Duplexer DU-HB-1, DU-HB-2, DU-HB-3 für das erste Frequenzband vorgesehen sind. Mittels eines individuellen Schalters SW kann jeder der Duplexer zum ersten Signalpfad SP1 hinzugekoppelt werden.

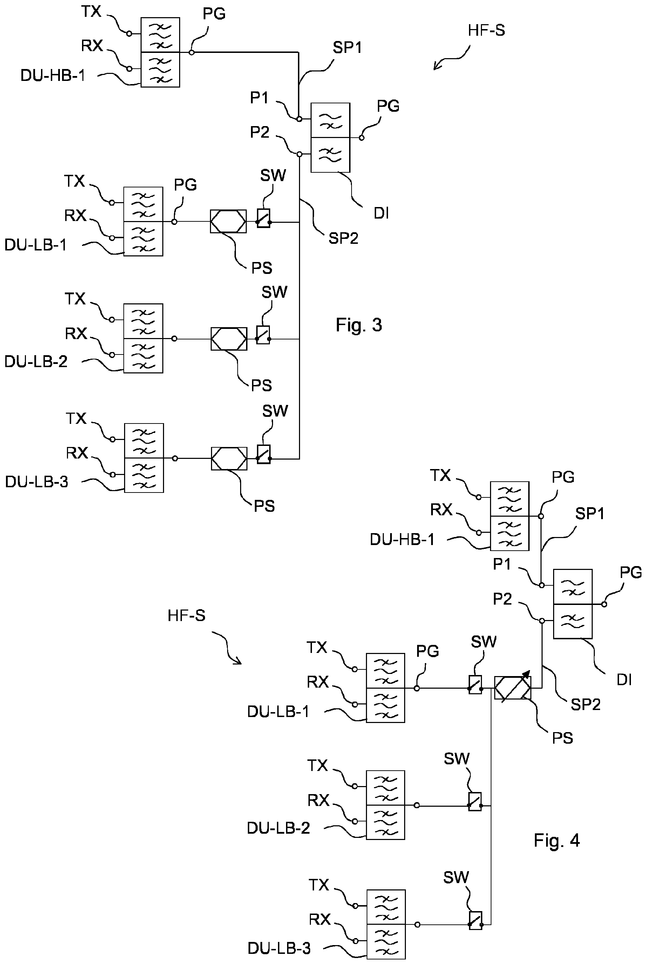

Im Wesentlichen analog dazu zeigt Figur 3 eine Ausführungsform einer HF-Schaltung HF-S, bei der drei Duplexer DU-LB-1, DU-LB-2, DU-LB-3 des zweiten Frequenzbands vorgesehen sind. Mittels Schalter kann jeder der drei Duplexer individuell zum zweiten Signalpfad SP2 hinzugekoppelt werden. Dabei kann jeder der drei Duplexer über einen speziell ihm zugeordneten Phasenschieber PS verfügen. Die Schalter sind vorzugsweise zwischen den Phasenschiebern und dem Diplexer verschaltet.

Figur 4 zeigt, wie anstelle der drei verschiedenen Phasenschieber ein einziger Phasenschieber im zweiten Signalpfad SP2 verschaltet sein kann. Dieser Phasenschieber PS ist dafür vorgesehen und geeignet,

Intermodulationsprodukte für alle drei Duplexer des zweiten Frequenzbands zu verhindern oder abzuschwächen.

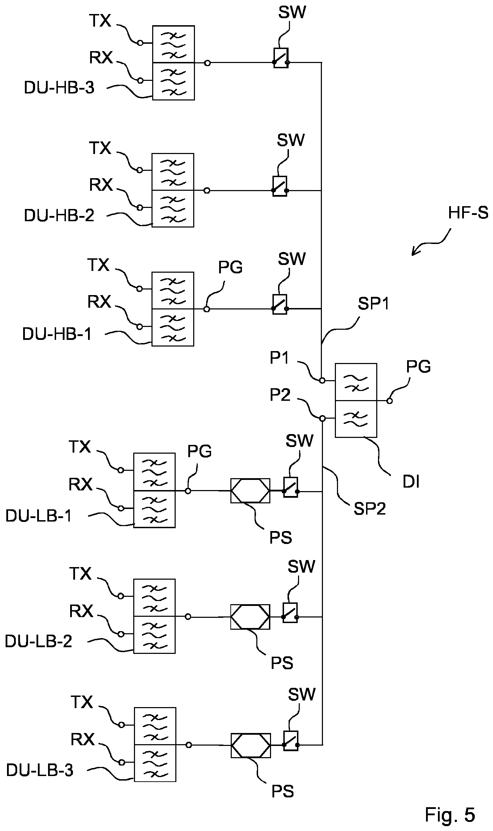

Figur 5 zeigt eine Ausführungsform, bei der sowohl im ersten Frequenzband als auch im zweiten Frequenzband jeweils drei Duplexer vorgesehen sind.

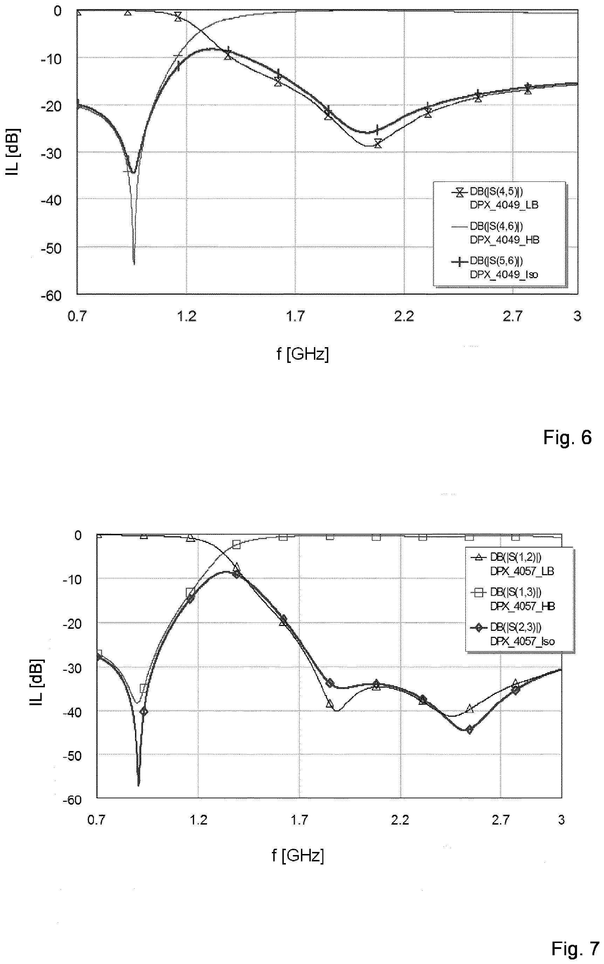

Figur 6 zeigt charakteristische Kurven eines typischen Diplexers mit relativ geringer Isolation.

Figur 7 zeigt charakteristische Kurven eines typischen Diplexers mit höherer Isolation.

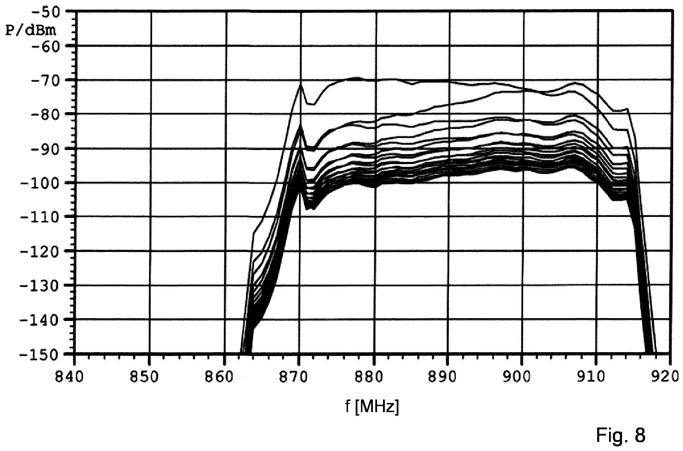

Figur 8 zeigt die Stärke der Intermodulations-Störung bei einer Carrier Aggregation der beiden Tx Bänder B5 und B7, wenn der Diplexer der Fig. 6 verwendet wird. Die verschiedenen Kurven repräsentieren dabei jeweils einen anderen Phasenversatz durch den Phasenschieber. Das Intermodulationsprodukt hat Frequenzkomponenten um 880 MHz: B7-Tx (2540 MHz) - 2 x B5-Tx (2 x 830 MHz) = B5-Rx (880 MHz). Die HF-Schaltung umfasst als Phasenschieber einen abstimmbaren Phasenschieber, dessen Phasenversatz einstellbar ist. Je nach gewähltem Phasenversatz kann eine um bis zu etwa 30 dB verringerte Intermodulations-Störung erhalten werden.

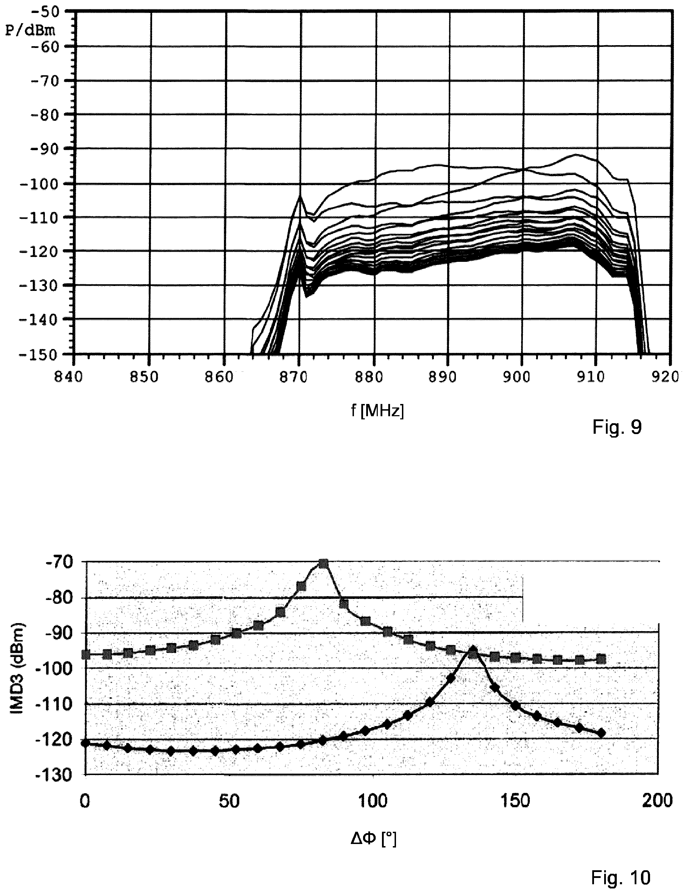

Entsprechend zeigt Figur 9 verschiedene Isolationswerte einer HF-Schaltung, die den "besseren" Diplexer der Figur 7 mit erhöhter Isolation - neben einem abstimmbaren Phasenschieber als Phasenschieber - enthält. Die unterschiedlichen in Figur 8 gezeigten Kurven stellen dabei die Isolationswerte bei variiertem Phasenversatz durch den Phasenschieber dar. Analog zur Figur 7 kann die Verringerung von Intermodulations-Störungen durch Wählen eines geeigneten Phasenversatzes um bis zu 30 dB verbessert werden.

Insgesamt zeigen die Figuren 6 bis 9, dass HF-Schaltungen sowohl mit schlechteren als auch mit besseren Diplexern deutlich von der neuen Schaltungstopologie profitieren.

Figur 10 zeigt die Intensität von Intermodulationsprodukten für HF-Schaltungen, jeweils mit einem der beiden aus Figur 6 gezeigten Diplexern und einem als Phasenschieber ausgestalteten Phasenschieber. Es zeigt sich, dass die verbesserte Isolation tatsächlich zu einer Verringerung der Intermodulationsprodukte führt - allerdings nur, wenn der Phasenschieber entsprechend optimal dimensioniert beziehungsweise eingestellt ist.

Die HF-Schaltung ist dabei nicht auf die beschriebenen oder gezeigten Ausführungsbeispiele beschränkt. Eine HF-Schaltung kann insbesondere weitere Schaltungskomponenten, Signalpfade, Filter, Schalter enthalten.

### Bezugszeichenliste

- DB-HP:: Durchlassbereich des Hochpasses des Diplexers
- DB-LP:: Durchlassbereich des Tiefenpasses des Diplexers
- DI:: Diplexer
- DU:: Duplexer
- DU-HB-1:: erster Duplexer des ersten Frequenzbands
- DU-HB-2:: zweiter Duplexer des ersten Frequenzbands
- DU-HB-3:: dritter Duplexer des ersten Frequenzbands
- DU-LB-1:: erster Duplexer des zweiten Frequenzbands
- DU-LB-2:: zweiter Duplexer des zweiten Frequenzbands
- DU-LB-3:: dritter Duplexer des zweiten Frequenzbands
- HF-S:: HF-Schaltung
- IS:: Isolation des Diplexers
- PG:: Gemeinsamer Port
- RX:: Empfangsport
- PS:: Phasenschieber
- SD:: Schalter
- SP1:: erster Signalpfad
- SP2:: zweiter Signalpfad
- TX:: Sendeport

## Patentansprüche

1. HF-Schaltung (HF-S), umfassend:
- einen Diplexer (DI) mit einem ersten Port (P1), einem gemeinsamen Port (PG) und einem zweiten Port (P2),
- einen ersten Duplexer (DU-HB-1) für ein erstes Frequenzband mit einem Sendeport (TX), einem gemeinsamen Port (PG) und einem Empfangsport (RX),
- einen ersten Duplexer (DU-LB-1) für ein zweites Frequenzband mit einem Sendeport (TX), einem gemeinsamen Port (PG) und einem Empfangsport (RX), wobei das erste Frequenzband das 2 GHz-Band oder das 2.5 GHz-Band und das zweite Frequenzband das 1 GHz-Band ist,
- einen ersten Signalpfad (SP1) zwischen dem gemeinsamen Port (PG) des ersten Duplexers (DU-HB-1, DU-LB-1, DU-HB-2, DU-LB-2, DU-HB-3, DU-LB-3) des ersten Frequenzbands und dem ersten Port (P1) des Diplexers (DI), wobei der erste Signalpfad (SP1) den gemeinsamen Port (PG) des ersten Duplexers (DU-HB-1, DU-LB-1, DU-HB-2, DU-LB-2, DU-HB-3, DU-LB-3) des ersten Frequenzbands mit dem ersten Port (pi) des Diplexers (DI) verbindet,
- einen zweiten Signalpfad (SP2) zwischen dem gemeinsamen Port (PG) des ersten Duplexers (DU-HB-1, DU-LB-1, DU-HB-2, DU-LB-2, DU-HB-3, DU-LB-3) des zweiten Frequenzbands und dem zweiten Port (P2) des Diplexers (DI),
- im zweiten Signalpfad (SP2) einen Phasenschieber (PS), eingerichtet zum Anpassen der Impedanzen des ersten Duplexer (DU-HB-1, DU-LB-1, DU-HB-2, DU-LB-2, DU-HB-3, DU-LB-3) des zweiten Frequenzbands und des Diplexers (DI) für zumindest eine Harmonische einer Sendefrequenz eines der Frequenzbänder, so dass zumindest ein Intermodulationsprodukt reduziert ist, wobei der Phasenschieber (PS) in seinem Phasenversatz abstimmbar ist.

2. HF-Schaltung nach dem vorherigen Anspruch, wobei der Diplexer (DI) ein Keramik-Diplexer ist.

3. HF-Schaltung nach einem der vorherigen Ansprüche, ferner umfassend einen zweiten oder mehrere weitere Duplexer (DU-HB-1, DU-LB-1, DU-HB-2, DU-LB-2, DU-HB-3, DU-LB-3) des ersten Frequenzbands, die parallel zum ersten Duplexer (DU-HB-1, DU-LB-1, DU-HB-2, DU-LB-2, DU-HB-3, DU-LB-3) des ersten Frequenzbands und mit dem ersten Signalpfad
(SP1) verschaltbar sind.

4. HF-Schaltung nach dem vorherigen Anspruch, ferner umfassend eine Schalteranordnung (SW), über die der erste Port (P1) des Diplexers (DI) mit einem oder mehreren der Duplexer (DU-HB-1, DU-LB-1, DU-HB-2, DU-LB-2, DU-HB-3, DU-LB-3) des ersten Frequenzbands verschaltbar ist.

5. HF-Schaltung nach einem der vorherigen Ansprüche, ferner umfassend einen zweiten oder mehrere weitere Duplexer (DU-HB-1, DU-LB-1, DU-HB-2, DU-LB-2, DU-HB-3, DU-LB-3) des zweiten Frequenzbands, die parallel zum ersten Duplexer (DU-HB-i, DU-LB-1, DU-HB-2, DU-LB-2, DU-HB-3, DU-LB-3) des zweiten Frequenzbands und mit dem zweiten Signalpfad
(SP2) verschaltbar sind.

6. HF-Schaltung nach dem vorherigen Anspruch, ferner umfassend eine Schalteranordnung (SW), über die der zweite Port (P2) des Diplexers (DI) mit einem oder mehreren der Duplexer (DU-HB-1, DU-LB-1, DU-HB-2, DU-LB-2, DU-HB-3, DU-LB-3) des zweiten Frequenzbands verschaltbar ist.

7. HF-Schaltung nach einem der vorherigen Ansprüche, wobei ein pro Duplexer (DU-HB-1, DU-LB-1, DU-HB-2, DU-LB-2, DU-HB-3, DU-LB-3) des zweiten Frequenzbands ein Phasenschieber (PS) im zweiten Signalpfad (SP2) vorgesehen ist.

8. Mobilfunkgerät, umfassend eine HF-Schaltung (HF-S) nach einem der vorherigen Ansprüche.

9. Verwendung einer HF-Schaltung (HF-S) nach einem der vorherigen Ansprüche in einer Frontend-Schaltung eines Mobilfunkgeräts.

## Claims

1. An RF circuit (HF-S) comprising:
- a diplexer (DI) having a first port (P1), a common port (PG) and a second port (P2),
- a first duplexer (DU-HB-1) for a first frequency band having a transmit port (TX), a common port (PG) and a receive port (RX),
- a first duplexer (DU-LB-1) for a second frequency band having a transmit port (TX), a common port (PG) and a receive port (RX), wherein the first frequency band is the 2 GHz band or the 2.5 GHz band and the second frequency band is the 1 GHz band,
- a first signal path (SP1) between the common port (PG) of the first duplexer (DU-HB-1, DU-LB-1, DU-HB-2, DU-LB-2, DU-HB-3, DU-LB-3) of the first frequency band and the first port (P1) of the diplexer (DI), wherein the first signal path (SP1) connects the common port (PG) of the first duplexer (DU-HB-1, DU-LB-1, DU-HB-2, DU-LB-2, DU-HB-3, DU-LB-3) of the first frequency band to the first port (P1) of the diplexer (DI),
- a second signal path (SP2) between the common port (PG) of the first duplexer (DU-HB-1, DU-LB-1, DU-HB-2, DU-LB-2, DU-HB-3, DU-LB-3) of the second frequency band and the second port (P2) of the diplexer (DI),
- in the second signal path (SP2) a phase shifter (PS), configured to adapt the impedances of the first duplexer (DU-HB-1, DU-LB-1, DU-HB-2, DU-LB-2, DU-HB-3, DU-LB-3) of the second frequency band and of the diplexer (DI) for at least one harmonic of a transmission frequency of one of the frequency bands, so that at least one intermodulation product is reduced, wherein the phase shifter (PS) is tunable in its phase offset.

2. The RF circuit according to the preceding claim, wherein the diplexer (DI) is a ceramic diplexer.

3. The RF circuit according to one of the preceding claims, further comprising a second or more further duplexers (DU-HB-1, DU-LB-1, DU-HB-2, DU-LB-2, DU-HB-3, DU-LB-3) of the first frequency band, which can be connected in parallel to the first duplexer (DU-HB-1, DU-LB-1, DU-HB-2, DU-LB-2, DU-HB-3, DU-LB-3) of the first frequency band and to the first signal path (SP1).

4. The RF circuit according to the preceding claim, further comprising a switch arrangement (SW), via which the first port (P1) of the diplexer (DI) can be connected to one or more of the duplexers (DU-HB-1, DU-LB-1, DU-HB-2, DU-LB-2, DU-HB-3, DU-LB-3) of the first frequency band.

5. The RF circuit according to one of the preceding claims, further comprising a second or more further duplexers (DU-HB-1, DU-LB-1, DU-HB-2, DU-LB-2, DU-HB-3, DU-LB-3) of the second frequency band, which can be connected in parallel to the first duplexer (DU-HB-1, DU-LB-1, DU-HB-2, DU-LB-2, DU-HB-3, DU-LB-3) of the second frequency band and to the second signal path
(SP2).

6. The RF circuit according to the preceding claim, further comprising a switch arrangement (SW), via which the second port (P2) of the diplexer (DI) can be connected to one or more of the duplexers (DU-HB-1, DU-LB-1, DU-HB-2, DU-LB-2, DU-HB-3, DU-LB-3) of the second frequency band.

7. The RF circuit according to one of the preceding claims, wherein a phase shifter (PS) is provided in the second signal path (SP2) per duplexer (DU-HB-1, DU-LB-1, DU-HB-2, DU-LB-2, DU-HB-3, DU-LB-3) of the second frequency band.

8. A mobile radio device comprising an RF circuit (HF-S) according to one of the preceding claims.

9. Use of an RF circuit (HF-S) according to one of the preceding claims in a front-end circuit of a mobile radio device.

## Revendications

1. Circuit HF (C-HF), comprenant :
- un diplexeur (DI) avec un premier port (P1), un port commun (PC) et un deuxième port (P2),
- un premier duplexeur (DU-HB-1) pour une première bande de fréquence avec un port d'émission (TX), un port commun (PC) et un port de réception (RX),
- un premier duplexeur (DU-LB-1) pour une deuxième bande de fréquence avec un port d'émission (TX), un port commun (PC) et un port de réception (RX), dans lequel la première bande de fréquence est la bande 2 GHz ou la bande 2,5 GHz et la deuxième bande de fréquence est la bande 1 GHz,
- un premier chemin de signal (CS1) entre le port commun (PC) du premier duplexeur (DU-HB-1, DU-LB-1, DU-HB-2, DU-LB-2, DU-HB-3, DU-LB-3) de la première bande de fréquence et le premier port (P1) du diplexeur (DI), dans lequel le premier chemin de signal (CS1) raccorde le port commun (PC) du premier duplexeur (DU-HB-1, DU-LB-1, DU-HB-2, DU-LB-2, DU-HB-3, DU-LB-3) de la première bande de fréquence au premier port (P1) du diplexeur (DI),
- un deuxième chemin de signal (CS2) entre le port commun (PC) du premier duplexeur (DU-HB-1, DU-LB-1, DU-HB-2, DU-LB-2, DU-HB-3, DU-LB-3) de la deuxième bande de fréquence et le deuxième port (P2) du diplexeur (DI),
- sur le deuxième chemin de signal (CS2), un déphaseur (DP) conçu pour adapter les impédances du premier duplexeur (DU-HB-1, DU-LB-1, DU-HB-2, DU-LB-2, DU-HB-3, DU-LB-3) de la deuxième bande de fréquence et du diplexeur (DI) pour au moins une harmonique d'une fréquence d'émission d'une des bandes de fréquence de sorte qu'au moins un produit d'intermodulation soit réduit, dans lequel le déphaseur (DP) peut être ajusté en ce qui concerne son déphasage.

2. Circuit HF selon la revendication précédente, dans lequel le diplexeur (DI) est un diplexeur céramique.

3. Circuit HF selon l'une des revendications précédentes, comprenant en outre un deuxième ou plusieurs autres duplexeurs (DU-HB-1, DU-LB-1, DU-HB-2, DU-LB-2, DU-HB-3, DU-LB-3) de la première bande de fréquence, qui peuvent être branchés de manière parallèle au premier duplexeur (DU-HB-1, DU-LB-1, DU-HB-2, DU-LB-2, DU-HB-3, DU-LB-3) de la première bande de fréquence et au premier chemin de signal (CS1).

4. Circuit HF selon la revendication précédente, comprenant en outre un ensemble commutateur (SW), par l'intermédiaire duquel le premier port (P1) du diplexeur (DI) peut être branché à un ou à plusieurs des duplexeurs (DU-HB-1, DU-LB-1, DU-HB-2, DU-LB-2, DU-HB-3, DU-LB-3) de la première bande de fréquence.

5. Circuit HF selon l'une des revendications précédentes, comprenant en outre une deuxième ou plusieurs autres duplexeurs (DU-HB-1, DU-LB-1, DU-HB-2, DU-LB-2, DU-HB-3, DU-LB-3) de la deuxième bande de fréquence, qui peuvent être branchés de manière parallèle au premier duplexeur (DU-HB-1, DU-LB-1, DU-HB-2, DU-LB-2, DU-HB-3, DU-LB3) de la deuxième bande de fréquence et au deuxième chemin de signal (CS2).

6. Circuit HF selon la revendication précédente, comprenant en outre un ensemble commutateur (SW), par l'intermédiaire duquel le deuxième port (P2) du diplexeur (DI) peut être branché à un ou à plusieurs des duplexeurs (DU-HB-1, DU-LB-1, DU-HB-2, DU-LB-2, DU-HB-3, DU-LB-3) de la deuxième bande de fréquence.

7. Circuit HF selon l'une des revendications précédentes, dans lequel il est prévu, sur le deuxième chemin de signal (CS2), un déphaseur (DP) par duplexeur (DU-HB-1, DU-LB-1, DU-HB-2, DU-LB-2, DU-HB-3, DU-LB-3) de la deuxième bande de fréquence.

8. Appareil de radiotéléphonie comprenant un circuit HF (C-HF) selon l'une des revendications précédentes.

9. Utilisation d'un circuit HF (C-HF) selon l'une des revendications précédentes dans un circuit frontal d'un appareil de radiotéléphonie.
